# EUROPEAN PATENT APPLICATION

(11) **EP 2 085 137 A1**
(43) Date of publication of application: **05.08.2009**
(21) Application number: 09001541.3
(22) Date of filing: 04.02.2009
(51) Int. Cl.: B01J 12/00, B01J 19/08

(54) **Conversion of carbon dioxide into useful organic products by using plasma technology**

(30) Priority: 04.02.2008 TW 97104132
(71) Applicant: National Tsing Hua University, Hsinchu 30013 (TW)
(72) Inventor: Yang, Arnold, Chang-Mou, Hsinchu (TW); Chang, Yi-Hsin, Keelung City 204 (TW); Chang, Chun-Chih, Taichung City 406 (TW)
(74) Representative: Hollatz, Christian

(57) **Abstract**

The present invention provides a plasma method for conversion of carbon dioxide into useful organic products. In this method, carbon dioxide and counterpart molecules are mixed in a reaction chamber and the plasma excitation is utilized to trigger chemical reactions. Depending on the magnitude of the input power and molecular structures of counterparts, the final product may be polymers, oligomers, or low molecular weight small molecules. The conversion yields of carbon dioxide and chemical structures of the resulting products are strongly dependent on the selection of the counterpart molecules. Through this plasma technology, carbon dioxide is converted into useful materials such as plastics or fuels. This method is not only used to remedy global warming but also to produce new materials and energy.

## Description

### Field of the Invention

The present invention relates to a method for conversion of carbon dioxide into useful organic products, it more specifically relates to a method using plasma technology to convert carbon dioxide with other molecules into useful organic products.

### Background of the Invention

In the last few decades, the rapid growth in world population and industrial development has lead to massively increased usage of fossil fuels such as coal, petroleum and natural gas and the resulting formation of carbon dioxide; moreover, due to the deforestation and the reduction of rain forest, the dynamic equilibrium of carbon dioxide formation and conversion has been seriously destroyed. Consequently carbon dioxide content in the atmosphere increases year by year; the seriousness of global warming attributed to carbon dioxide emission has increased, and the potential dangers to humanity have driven many countries to research the reduction of carbon dioxide.

The reduction technology of carbon dioxide currently can be divided into two methods, physics-based and chemistry-based. For physics-based methods, carbon dioxide is captured from atmosphere and then stored underground or under the sea bed using high pressure compression. From the viewpoint of equilibrium and cycling of carbon dioxide on earth, the amount of carbon dioxide has not been reduced; hence, the use of chemistry-based methods to convert carbon dioxide into useful materials has become the core of carbon dioxide reduction technology. However, although several chemistry-based methods have been developed for the conversion of carbon dioxide, these chemical processes have the following limits: First, since carbon dioxide is very chemically inactive, catalysts must be used for conversion reactions, but catalysts are very expensive and the reaction lifetime is limited; Second, since carbon dioxide and its counterpart molecules are usually in different phases at room temperature and atmospheric pressure, the reaction must be carried out under high temperature and high pressure environments; Third, such long reaction times are required for the chemical reactions, that the reaction times can be several hours to several days depending on the types of catalysts; all the above mentioned issues have limited the massive demands for carbon dioxide conversion in industries. Moreover, such chemical processes are not suitable for household applications.

Based on these considerations, a plasma-based technology is presented for carbon dioxide conversions. When molecules enter into electric fields, they are excited and ionized by collision with accelerated electrons to generate various species such as atoms, electrons, ions, free radicals, etc. The mixture of these species is plasma. These activated species generated by plasma bombardments can recombine to form new products. The molecules used in this plasma processes do not have to contain chemically active groups, such as C=C bonds. As compared to the complicated processes and steps in conventional chemical syntheses, the plasma process is simple and fast. Besides, no solvent needs to be used and the hazard to the environment is greatly reduced; moreover, mass production can be easily reached to satisfy economic efficiency in industries. Besides, since plasma can be initiated in a simple device, it can thus be miniaturized to apply in portable or mobile commercial products, which will be a great advantage for the plasma technology to be extended to more applications.

Some studies have been aimed at the reaction mechanism of carbon dioxide in plasma. Carbon dioxide consists of two strong covalent bonds with low chemical activity; the conventional synthesis of carbon dioxide has to be induced only using catalyst activation. Buser et al. (J. App. Phy. 41, 472, 1970) found that carbon dioxide in plasma can be decomposed into carbon monoxide through vibration excitation. It was reported that as carbon dioxide is decomposed via the anti-symmetrical stretching mechanism, the initial energy is 0.1 electron volt (eV) and the energy required to overcome the band gap is 5.5 eV. This energy is smaller than the direct dissociation energy of C=O bond, which is about 8 eV. Therefore, via plasma activation, the bond dissociation of carbon dioxide can be achieved at a lower energy level, and the subsequent recombined reactions can be carried out. Besides, the past studies reported that the carbon dioxide can be converted into hydrophilic functional groups by plasma activation, such as carboxylic acid or alcohol, etc. When such derivative functional groups from carbon dioxide are attached to the material surface, hydrophilic properties of material surfaces can be enhanced.

### Summary of the Invention

The objective of the present invention is to provide a plasma technology wherein a CO₂ molecule in the reaction chamber, when bombarded by high speed charged particles, forms molecular fragments that have strong reactivity; in the mean time, when counterpart molecules are mixed with the plasma reaction, the resulting products, depending on the parameters, can be small molecules, oligomers or polymers.

Another objective of the present invention is to provide a plasma technology which can be used to activate carbon dioxide and trigger its reactions with counterpart molecules, and the resulting products can be small molecules, oligomers and polymers; in such technological conversion process of carbon dioxide, no catalyst or solvent needs to be used, and high pressure is also not needed to compress carbon dioxide gas; therefore, it has advantages such as: reactions can be carried out at room temperature, the reaction rate is fast, etc.; moreover, it can be used directly and effectively in the solving of global warming, energy and material insufficiency issues.

Yet another objective of the present invention is to provide a method using plasma technology to convert carbon dioxide into organic products with steps including: providing a reaction chamber; introducing a counterpart molecules and carbon dioxide into the reaction chamber; and initiating plasma in the reaction chamber; wherein the counterpart molecule and carbon dioxide will form organic products by plasma activation.

Another objective of the invention is to provide a plasma technology to convert carbon dioxide into organic products, wherein the counterpart molecule consists one or several compounds; it can also be a compound that contains aromatic rings, for example, single ring or multiple rings compounds, a compound that contains unsaturated bonds, for example, the long-chain unsaturated hydrocarbon of alkenes and alkynes, or a compound that contains entirely saturated bonds, for example, the long-chain hydrocarbon of alkanes or water molecule.

Another objective of the present invention is to provide a plasma technology to convert carbon dioxide into organic products, wherein the counterpart molecule can be, at room temperature, solid, liquid or gas; if it is solid or liquid, it can be vaporized by heat, with plasma assistance or a combination of both in the reaction chamber, it can also be vaporized outside the reaction chamber. Gas monomer can be injected directly into the reaction chamber or introduced into the reaction chamber by carrier gas.

Another objective of the present invention is to provide plasma technology to convert carbon dioxide into organic products, wherein the reaction chamber could be made of glass or metallic materials.

Also another objective of the present invention is to provide a plasma technology to convert carbon dioxide into organic products, wherein the plasma types, according to supply ways, can be microwave plasma, RF plasma, or DC plasma; according to operation pressure, can be low pressure plasma, for example: capacitive coupled plasma or inductive coupled plasma, or atmosphere plasma, for example: electron beam discharge, corona discharge or dielectric discharge.

Another objective of the present invention is to provide a plasma technology to convert carbon dioxide into organic products, wherein the reaction chamber pressure is 0.01∼760 torr, plasma power is 0.1∼1000 W, or better at 10∼300 W.

Another objective of the present invention is to provide a plasma technology to convert carbon dioxide into organic products, wherein the products can be gas, liquid or solid; they can also be polymers, oligomers or small molecules; they can also be a compound that contains OH groups, carboxylic groups or ester groups.

Another objective of the present invention is to provide a plasma technology to convert carbon dioxide into organic products, wherein oligomers and small molecules can be used in the fuel application, polymers can be used in plastic products.

Another objective of the present invention is to provide a plasma technology to convert carbon dioxide into organic products; according to the design of embodied device, it can be applied in the portable device, for example: in exhaust pipes of automobiles or motorcycles, or applied in the fixed device, for example: in smokestacks of factories.

### Brief Description of the Drawings

Figure 1 is an illustration of the instrument used in the embodiment of the present invention using plasma technology to convert carbon dioxide into organic products.
Figure 2 shows the IR spectra of organic products obtained through plasma activation reaction of ethyl naphthalene, toluene and decadiene with carbon dioxide in the first embodiment of the present invention.
Figure 3A shows the X-ray photoelectron C1s spectrum of organic products obtained through plasma activation reaction of ethyl naphthalene, toluene and decadiene with carbon dioxide in the first embodiment of the present invention.
Figure 3B shows the curve-fitting results of the X-ray photoelectron C1s spectra of organic products obtained through plasma activation reaction of ethyl naphthalene, toluene and decaidene with carbon dioxide in the first embodiment of the present invention.
Figure 4 shows the IR spectra of organic products obtained through plasma activation reaction of gasoline, kerosene, and diesel oil with carbon dioxide in the second embodiment of the present invention.
Figure 5A shows the X-ray photoelectron C1s spectra of organic product obtained through plasma activation reaction of gasoline, kerosene, and diesel oil with carbon dioxide in the second embodiment of the present invention.
Figure 5B shows the curve fitting results of the X-ray photoelectron C1s spectra of organic products obtained through plasma activation reaction of gasoline, kerosene, and diesel oil with carbon dioxide in the second embodiment of the present invention.
Figure 6 shows the IR spectra of organic products obtained through plasma activation reaction of ethyl naphthalene and water with carbon dioxide in the third embodiment of the invention.

### Detailed Description of the Invention

In the invention, plasma technology is adopted to activate carbon dioxide with counterpart molecules in the reaction chamber and to perform chemical bond breaking and re-combination reactions. In the following, the related figures will be referred to for the description of better embodiment of the present invention, wherein the same component will be described by the same symbol.

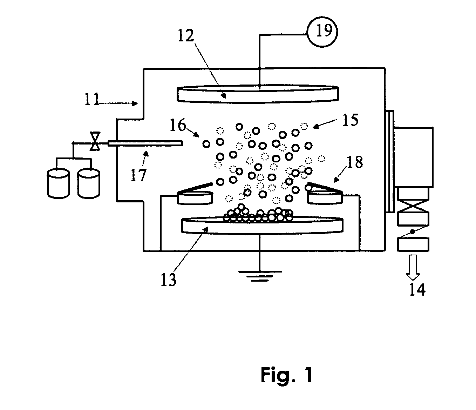

For the steps of a better embodiment of the present invention, please refer to figure 1. Figure 1 is the perspective view diagram of capacitive coupled plasma. First, carbon dioxide conversion reaction is conducted in reaction chamber 11. Reaction chamber 11 can be glass, metal or other alloy; in reaction chamber 11, it includes an upper electrode 12 and a lower electrode 13, which are used to generate plasma. Reaction chamber 11 can be pumped down to vacuum through vacuum ventilation end 14. Then we introduce carbon dioxide 15 and the counterpart molecule 16 into the reaction chamber 11; if counterpart molecule 16 is gas, it can be injected into reaction chamber 11 through injection end 17, or counterpart molecule 16 can be pushed into the reaction chamber 11 through carrier gas and through the injection end 17; if counterpart molecule 16 is liquid or solid, it can be vaporized by heating, vaporized with plasma assistance or vaporized in combination way in the source boat 18 of reaction chamber 11 and get mixed with carbon dioxide; or it can be vaporized by heating outside the reaction chamber 11, and then introduced through injection end 17 into the reaction chamber 11.

Next, we are going to describe the experimental parameters of better embodiment of the current invention. First, counterpart molecule 16 can be solid, liquid or gas, it can also be inorganic, for example: water can also be organic; in the structure, it can be a compound that contains unsaturated bonds or a compound that contains entirely saturated bonds, they include: single ring or multiple rings compounds, for example: aromatic ring type, long-chain unsaturated hydrocarbon compounds or long-chain saturated hydrocarbon compounds, for example: alkene, alkyne hydrocarbons; or alkane hydrocarbons. We then introduce counterpart molecules 16 and carbon dioxide into the vacuum reaction chamber 11 with reaction chamber vacuum level of 0.01∼760 torr. Next, we turn on the plasma to start the activation reaction, here the so-called plasma, according to the supply way, can be microwave plasma, RF plasma or DC plasma; or according to operation pressures, can be low pressure plasma, for example: capacitively coupled plasma or inductively coupled plasma, or atmosphere plasma, for example: electron beam discharge, corona discharge or dielectric discharge; the operation power of the plasma is in the range of 0.1∼1000W, or better controlled at 1∼500 W or especially good at 10-300 W. Through the control of different plasma parameters, the counterpart molecule structures, and mixing proportions, products generated could be gas, liquid or solid, they can also be small molecules, oligomers and polymers, or it can be compounds with OH groups, carboxylic groups or ester groups.

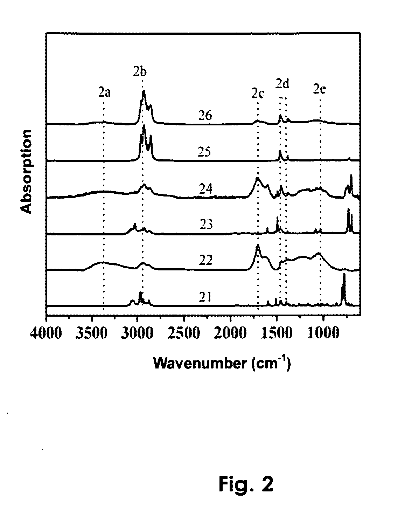

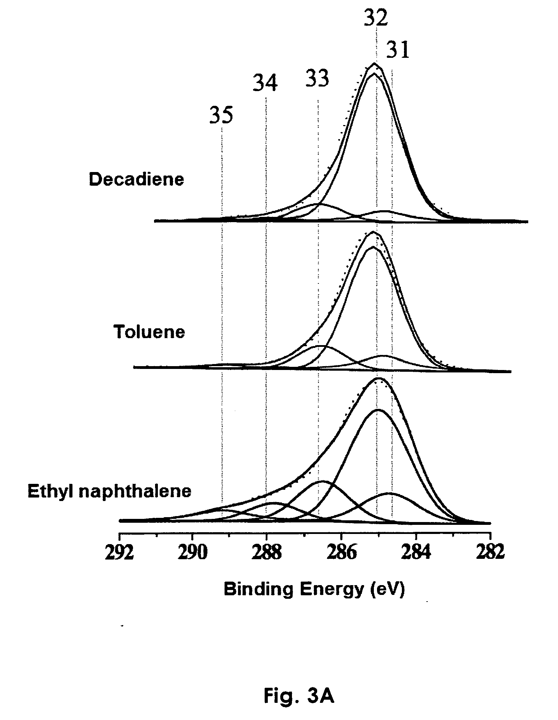

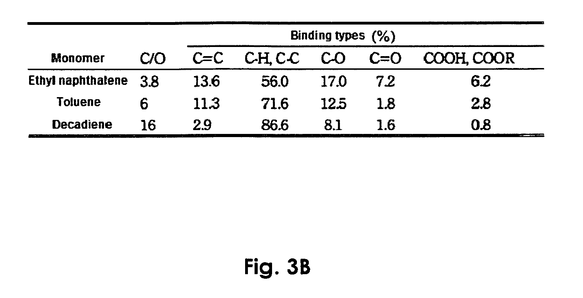

In the first embodiment of the present invention, ethyl naphthalene was selected as the counterpart molecules, plasma power was controlled at 200 W, after a reaction time of 5 minutes, and the resulting product was polymer with molecular weight in the range of 60,000-100,000. The IR spectrum of this polymer product is as shown in curve 22 of figure 2, which proves that through the use of such plasma activation technology, we can indeed convert carbon dioxide into products that contain carboxylic acid or OH group. When we reduced the plasma power to 10 W, then the resulting product was oligomers of low molecular weight with a viscous property. This proves that through the adjustment of plasma power, we can control the molecular weight of the product converted from carbon dioxide. If we changed the counterpart molecules into toluene or decadiene, then the IR spectra of obtained polymer products were as shown in 24, 26 of figure 2, and it can be seen that through the change of the structure of the counterpart molecules, carboxylic acid or OH groups can be effectively connected to the products, but only somehow different in the amounts of these groups. Its quantitative functional groups can be calculated from X-ray photo-electron C1s spectra as shown in figure 3A, and the curve fitting result are as shown in figure 3B. It can be seen that when the counterpart molecules consist of aromatic ring structures, more carbon dioxide derived functional groups can be connected to the products, which includes ether/alcohol groups (C-O), carbonyl group (C=O) and carboxylic group (COOR).

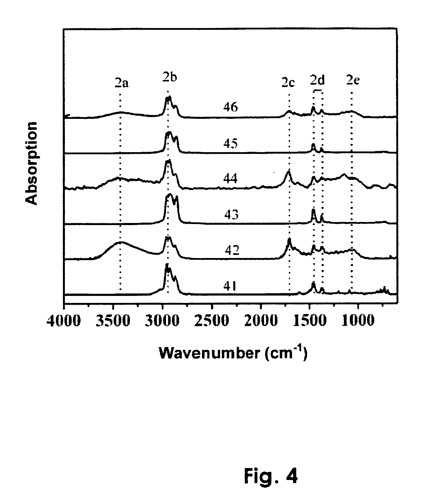

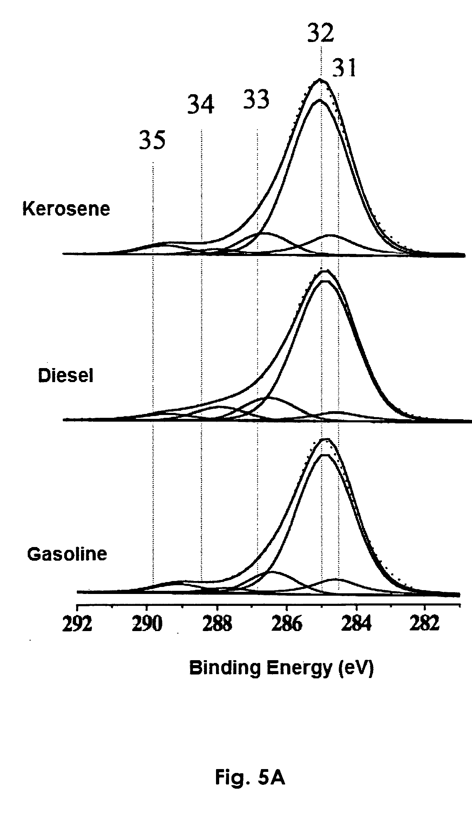

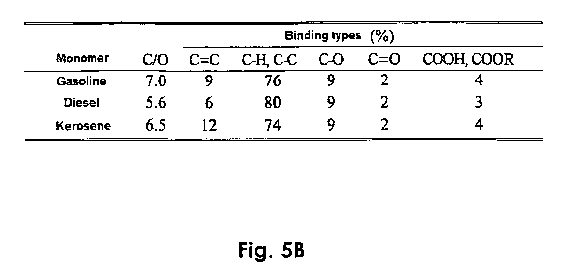

In the second embodiment of the present invention, the counterpart molecules for carbon dioxide conversion reaction can be petroleum fuel, which includes gasoline, diesel oil and kerosene, etc.; the obtained products could be different depending on the plasma powers and the mixing ratios between carbon dioxide and counterpart molecules, which could be gas, liquid and solid compounds; the IR spectra are shown in figure 4, and the X-ray photoelectron spectra are as shown in figure 5A, 5B. When different structures of counterpart molecules are used, the carbon dioxide derived functional groups are observed on obtained products, including ether/alcohol groups (C-O), carbonyl group (C=O) and carboxylic group (COOR). It can thus be seen that after petroleum fuel and carbon dioxide were activated by plasma, they can co-react to form products that are mainly consisted of hydrocarbons containing OH group and COOR group. If these products are volatile compounds, it can then be used as fuel.

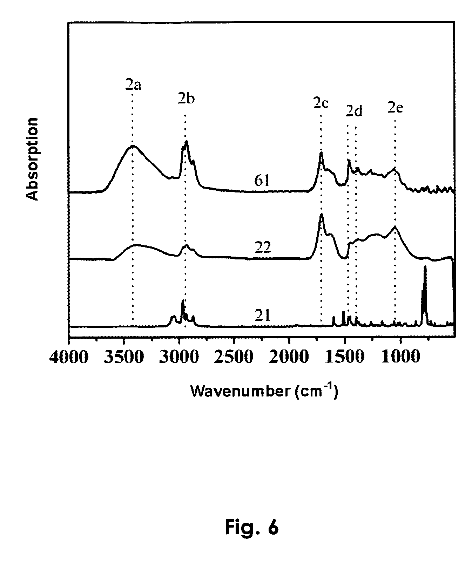

In the third embodiment of the present invention, ethyl naphthalene and water are selected as counterpart molecules, both monomers will be vaporized and injected into the plasma reaction chamber with plasma power controlled at 200 W. After 5 minutes of reaction, the IR spectrum of the obtained product is as shown in curve 61 of figure 6; when compared to product that was not added with water molecule, the result is as in curve 22; it can be seen from the result that when water molecule is added into the co-reaction system of carbon dioxide and naphthalene, the intensity of OH absorption in the product increased obviously, which proves that the adding of water molecule is helpful to the generation of OH group in the product converted from carbon dioxide. Since the OH group is combustible functional groups, the products can thus be used as fuel.

From the products due to the embodiment of the technology of present invention, oligomers and small molecules can be used as fuel and polymers can be used as plastic products. Moreover, the current invention, depending on the design of the embodied device, can be applied in the portable device, for example: applied in exhaust pipes of automobiles or motorcycles, or can be applied in the fixed device, for example: in smokestacks of factories.

Although the present invention has been disclosed above through preferred embodiments and the figures, it is not limited to the scope of the present invention. Anyone who is familiar with the prior art can make changes and modifications without deviating from the spirit and scope of the present invention. Therefore, the scope of the present invention should be defined by what is claimed.

This invention discloses a method of conversion of carbon dioxide into organic products using plasma technology comprising:
(a) providing a reaction chamber;
(b)introducing a counterpart molecule and carbon dioxide into the reaction chamber, and
(c) initiating a plasma in the reaction chamber,
and wherein
(i) the reaction chamber is in the pressure of 0.01-760 torr;
(ii) the counterpart molecule consists of at least one compound with unsaturated bonds or wholly saturated bonds; and
(iii) the plasma in the power of 0.1-1000W is low pressure plasma or atmosphere plasma.

In preferred embodiment, the counter molecule is solid, liquid or gaseous compound at room temperature. The counter molecule is water molecule. The compounds with unsaturated bonds comprise hydrocarbon with one or more benzene ring and hydrocarbon of alkene and alkyne. The compounds with wholly saturated bonds comprise hydrocarbon of alkane. The low pressure plasma is capacitively coupled plasma or inductively coupled plasma. The atmosphere plasma is electron beam discharge plasma, corona discharge plasma or dielectric discharge plasma.
In preferred embodiment, the solid or liquid compound is vaporized in the reaction chamber by heating, with plasma assistance or a combination of both. The solid or liquid compound is vaporized outside the reaction chamber and the vapor is introduced into the reaction chamber directly or by carrier gas.

This invention also discloses an organic product, which
(i) is a compound containing hydroxyl group, carboxylic group or ester group; and
(ii) exists in the form of solid, liquid or gas,
wherein the compound is a polymer, an oligomer or a small molecule.

The organic product of this invention is applied as a fuel or a material for producing plastic products.

This invention further discloses a device comprising:
(a) a reaction chamber with or without a vacuum ventilation end;
(b)an apparatus capable of producing electric field in the reaction chamber;
(c) a plasma generator; and
(d) an injection end on the reaction chamber,
and wherein
(i) the reaction chamber is made of glass or metallic materials;
(ii) the apparatus capable of producing electric field is selected from a group of electrodes or a coil;
(iii) the plasma generator which can generate low pressure plasma or atmosphere plasma is powered by microwave plasma, radio frequency (RF) plasma or direct current (DC) plasma; and
(iv) the injection end is applied to introduce the carbon dioxide and the counterpart molecule in gaseous state into the reaction chamber.

The device further comprises a source boat in the reaction chamber for vaporizing the counterpart molecule in liquid state or solid state.

In preferred embodiment, the device is a portable device or a fixed device, wherein
(i) the portable device can be applied in exhaust pipes of automobiles or motorcycles; and
(ii) the fixed device can be used in factory smokestacks.

## Claims

1. A method of conversion of carbon dioxide into organic products using plasma technology comprising:
(a) providing a reaction chamber;
(b)introducing a counterpart molecule and carbon dioxide into the reaction chamber, and
(c) initiating a plasma in the reaction chamber,
and wherein
(iv) the reaction chamber is in the pressure of 0.01-760 torr;
(v) the counterpart molecule consists of at least one compound with unsaturated bonds or wholly saturated bonds; and
(vi) the plasma in the power of 0.1-1000W is low pressure plasma or atmosphere plasma.

2. The method of claim 1, wherein
(a) the counter molecule is solid, liquid or gaseous compound at room temperature;
(b) the counter molecule is water molecule;
(c) the compounds with unsaturated bonds comprise hydrocarbon with one or more benzene ring and hydrocarbon of alkene and alkyne;
(d) the compounds with wholly saturated bonds comprise hydrocarbon of alkane;
(e) the low pressure plasma is capacitively coupled plasma or inductively coupled plasma; and
(f) the atmosphere plasma is electron beam discharge plasma, corona discharge plasma or dielectric discharge plasma.

3. The method of claim 2, wherein
(i) the solid or liquid compound is vaporized in the reaction chamber by heating, with plasma assistance or a combination of both;
(ii) the solid or liquid compound is vaporized outside the reaction chamber and the vapor is introduced into the reaction chamber directly or by carrier gas.

4. An organic product produced by the method of claim 1, which
(i) is a compound containing hydroxyl group, carboxylic group or ester group; and
(ii) exists in the form of solid, liquid or gas,
wherein the compound is a polymer, an oligomer or a small molecule.

5. The organic product of claim 4 which is applied as a fuel or a material for producing plastic products.

6. A device for carrying out the method of claim 1 comprising:
(a) a reaction chamber with or without a vacuum ventilation end;
(b)an apparatus capable of producing electric field in the reaction chamber;
(c) a plasma generator; and
(d) an injection end on the reaction chamber,
and wherein
(v) the reaction chamber is made of glass or metallic materials;
(vi) the apparatus capable of producing electric field is selected from a group of electrodes or a coil;
(vii) the plasma generator which can generate low pressure plasma or atmosphere plasma is powered by microwave plasma, radio frequency (RF) plasma or direct current (DC) plasma; and
(viii) the injection end is applied to introduce the carbon dioxide and the counterpart molecule in gaseous state into the reaction chamber.

7. The device of claim 6, which further comprises a source boat in the reaction chamber for vaporizing the counterpart molecule in liquid state or solid state.

8. The device of claim 6, which is a portable device or a fixed device, wherein
(i) the portable device can be applied in exhaust pipes of automobiles or motorcycles; and
(ii) the fixed device can be used in factory smokestacks.
